# EUROPEAN PATENT SPECIFICATION

(11) **EP 2 287 863 B1**
(45) Date of publication and mention of the grant of the patent: **15.11.2017**
(21) Application number: 10162168.8
(22) Date of filing: 06.05.2010
(51) Int. Cl.: H01F 10/32, H01F 41/30

(54) **Magnetic tunnel junction device and method for manufacturing the same**
Vorrichtung mit magnetischem Tunnelübergang und Verfahren zu ihrer Herstellung
Composant à junction tunnel magnétique et sa méthode de fabrication

(30) Priority: 21.08.2009 KR 20090077492
(43) Date of publication of application: 23.02.2011
(73) Proprietor: Korea Institute of Science and Technology, Seoul 136-791 (KR)
(72) Inventor: Choi, Gyung-Min, Seoul 136-130 (KR); Min, Byoung Chul, Gyeonggi-do 423-030 (KR); Shin, Kyung Ho, Seoul 139-230 (KR)
(74) Representative: Delorme, Nicolas

(56) References cited:
- US-A1- 2007 086 121
- US-A1- 2008 088 980
- US-A1- 2008 180 991
- US-A1- 2009 080 124

## Description

### BACKGROUND OF THE INVENTION

### (a) Field of the Invention

The present invention relates to a magnetic tunnel junction device and a method for manufacturing the same. More particularly, it relates to a magnetic tunnel junction device using a perpendicular magnetic anisotropic material, and a method of manufacturing the same.

### (b) Description of the Related Art

Recently, various types of memories have been developed. For example, a magnetic random access memory (MRAM), a phase-change random access memory (PRAM), and a resistive random access memory (RRAM) have been developed.

The MRAM uses a magnetic tunnel junction (MJT) element as a data storage element. The magnetic tunnel junction is included in a memory cell and thus forms a ferromagnetic tunnel junction. The magnetic tunnel junction element is structured with a magnetic layer, an insulating layer, and a magnetic layer, and a current flows in the insulating layer through the tunneling mechanism. Here, when relative magnetization directions of the two magnetic layers are equivalent to each other, the magnetic tunnel junction element has low resistance. On the contrary, when the two magnetic layers have different magnetization directions, the magnetic tunnel junction element has high resistance. The low resistance and the high resistance indicate digital data, respectively corresponding to 0 and 1.

Thermal stability is defined as the ability of maintaining the digital data for a long period of time. The thermal stability is proportional to anisotropy energy of the magnetic layer of the magnetic tunnel junction element. Most anisotropy energy of a horizontal magnetic anisotropic ferromagnetic substance used as a material of the magnetic tunnel junction element is shape anisotropy energy, and therefore the entire anisotropy energy is small. In order to solve this problem, a perpendicular magnetic anisotropic ferromagnetic substance having high crystalline anisotropy energy is used as a material of the magnetic tunnel junction element. Accordingly, the entire anisotropy energy of the magnetic tunnel junction device is large so that the magnetic tunnel junction device can have superior thermal stability with a small volume.

The above information disclosed in this Background section is only for enhancement of understanding of the background of the invention and therefore it may contain information that does not form the prior art that is already known in this country to a person of ordinary skill in the art. US 2008/088980 A1 discloses a magnetic tunnel junction comprising a CoCrPtTa type of fixed layer and FePtB type of free layer both depicting a L1₀ structure with perpendicular magnetic anisotropy and sandwiching an insulating layer.

US 2007/086121 A1 discloses a magnetic tunnel junction comprising CoCrPtTa type of fixed and free layers both depicting a L1₀ structure with perpendicular magnetic anisotropy and sandwiching an insulating layer. Layers of the CoFeB type with in-plane magnetic anisotropy are directly inserted on each side of the tunnel barrier.

### SUMMARY OF THE INVENTION

The present invention has been made in an effort to provide a magnetic tunnel junction device, according to claims 1 and 6, having advantages of increasing a regeneration signal value and improving thermal stability. In addition, the present invention provides a manufacturing method of the magnetic tunnel junction device, according to claims 7 and 12. A magnetic tunnel junction device according to a first embodiment of the present invention includes: i) a first magnetic layer; ii) an insulating layer disposed on the first magnetic layer; and iii) a second magnetic layer disposed on the insulating layer. The first and second magnetic layers have perpendicular magnetic anisotropy and include amorphizing element B (boron). The insulating layer includes a compound having a chemical formula of D_{100-z}E_{z}, and D may be at least one element selected from a group consisting of lithium (Li), beryllium (Be), sodium (Na), magnesium (Mg), niobium (Nb), titanium (Ti), vanadium (V), tantalum (Ta), barium (Ba), palladium (Pd), zirconium (Zr), holmium (Ho), potassium (K), and silver (Ag), and E is at least one element selected from a group consisting of oxygen (O), nitrogen (N), carbon (C), hydrogen (H), selenium (Se), chlorine (Cl), and fluorine (F). At least one of the first and second magnetic layers may have a cubic or tetragonal structure.

The magnetic tunnel junction device according to the first embodiment of the present invention further include i) a first horizontal magnetic anisotropic magnetic layer disposed between the second magnetic layer and the insulating layer and ii) a first crystalline inductive layer disposed on the second magnetic layer. The first horizontal magnetic anisotropic magnetic layer may include at least one element selected from a group consisting of Fe, CoFe, and CoFeB. The compound included in at least one of the first and second magnetic layers has a chemical formula of (Fe₁₀₀₋ₓPdₓ)_{100-y}B_{y} or (Fe₁₀₀₋ₓPtₓ)_{100-y}B_{y} and the first crystalline inductive layer includes at least one element selected from a group consisting of Pd, Pt, Au, and Fe. The magnetic tunnel junction device according to the first embodiment of the present invention may further include i) a second horizontal magnetic anisotropic magnetic layer disposed between the first magnetic layer and the insulating layer and ii) a second crystalline inductive layer disposed under the first magnetic layer.

A magnetic tunnel junction device according to the second embodiment of the present invention includes: i) a crystalline inductive layer; ii) a perpendicular magnetic anisotropic magnetic layer including amorphizing element B (boon), disposed on the crystalline inductive layer and including a compound having a chemical formula of (Fe₁₀₀₋ₓPdₓ)_{100-y}B_{y} or (Fe₁₀₀₋ₓPtₓ)_{100-y}B_{y}; iii) a horizontal magnetic anisotropic magnetic layer disposed on the perpendicular magnetic anisotropic magnetic layer; iv) an insulating layer disposed on the horizontal magnetic anisotropic magnetic layer; v) a horizontal magnetic anisotropic inductive layer disposed on the insulating layer; and vi) a perpendicular magnetic inductive magnetic layer disposed on the horizontal magnetic anisotropic magnetic layer.

A manufacturing method of a magnetic tunnel junction device according to the first embodiment of the present invention includes: i) providing a first magnetic layer including an amorphizing element; ii) providing an insulating layer on the first magnetic layer; iii) providing a second magnetic layer including an amorphizing element on the insulating layer; and iv) crystallizing the first and second magnetic layers by performing thermal treatment on the first magnetic layer, the insulating layer, and the second magnetic layer.

In the crystallizing of the first and second magnetic layers, the first and second magnetic layers have perpendicular magnetic anisotropy. In the crystallizing of the first and second magnetic layers, the thermal treatment may be performed on the first magnetic layer, the insulating layer, and the second magnetic layer at 300°C to 600°C.

The manufacturing method according to the first embodiment of the present invention further include i) providing a horizontal magnetic anisotropic magnetic layer between the second magnetic layer and the insulating layer and ii) providing a crystalline inductive layer on the second magnetic layer. The manufacturing method according to the first embodiment of the present invention may further include i) providing another horizontal magnetic anisotropic magnetic layer between the first magnetic layer and the insulating layer and ii) providing a crystalline inductive layer under the first magnetic layer.

A manufacturing method of a magnetic tunnel junction device according to the second embodiment of the present invention includes: i) providing a crystalline inductive layer; ii) providing a magnetic layer including a compound having a chemical formula of (Fe₁₀₀₋ₓPdₓ)_{100-y}B_{y} or (Fe₁₀₀₋ₓPtₓ)_{100-y}B_{y}; on the crystalline inductive layer; iii) providing a first horizontal magnetic anisotropic magnetic layer on the magnetic layer; iv) providing an insulating layer on the first horizontal magnetic anisotropic magnetic layer; v) providing a second horizontal magnetic anisotropic magnetic layer on the insulating layer; vi) providing a perpendicular magnetic anisotropic magnetic layer on the second horizontal magnetic anisotropic magnetic layer; and vii) crystallizing the magnetic layer by performing thermal treatment on the crystalline inductive layer, the magnetic layer, the first horizontal magnetic anisotropic magnetic layer, the insulating layer, the second horizontal magnetic anisotropic magnetic layer, and the perpendicular magnetic anisotropic magnetic layer,

In the crystallizing of the magnetic layer, the magnetic layer has perpendicular magnetic anisotropy and include amorphizing element B (boron). According to the present invention, the insulating layer is deposited on the amorphous magnetic layer so that the insulating layer is deposited with low flatness index. Accordingly, the magnetic tunnel junction device having a high regeneration signal value can be manufactured. In addition, a crystal structure of the amorphous magnetic layer is recovered through thermal treatment so that it has perpendicular magnetic anisotropy. Accordingly, the magnetic tunnel junction device having higher thermal stability can be manufactured. As a result, the regeneration signal value and thermal stability of the magnetic tunnel junction device can be increased so that the magnetic tunnel junction device can be used in a magnetic random access memory (MRAM) or a high frequency oscillator.

### BRIEF DESCRIPTION OF THE DRAWINGS

FIG. 1 schematically shows a cross-sectional view of a magnetic tunnel junction device according to an exemplary embodiment of the present invention.
FIG. 2 schematically shows a flowchart of a manufacturing method of the magnetic tunnel junction device of FIG. 1.
FIG. 3 schematically shows a magnetic tunnel junction device formed of a sequentially stacked first magnetic layer, insulating layer, and second magnetic layer before thermal treatment.
FIG. 4 schematically shows a cross-sectional view of a magnetic tunnel junction device according to a first embodiment of the present invention.
FIG. 5 schematically shows a cross-sectional view of a magnetic tunnel junction device according to a second embodiment of the present invention.
FIG. 6 is an X-ray diffraction graph of a magnetic tunnel junction device manufactured according to a first experimental example.
FIG. 7 is a magnetic hysteresis curve of a magnetic layer of a magnetic tunnel junction device manufactured according to a second experimental example before thermal treatment and after thermal treatment.

### DETAILED DESCRIPTION OF THE EMBODIMENTS

It will be understood that when an element is referred to as being "on" another element, it can be directly on another element or intervening elements may be present therebetween. In contrast, when an element is referred to as being "directly on" another element, there are no intervening elements therebetween.

It will be understood that, although the terms first, second, third, etc. may be used herein to describe various elements, components, regions, layers, and/or sections, they are not limited thereto. These terms are only used to distinguish one element, component, region, layer, or section from another element, component, region, layer, or section. Thus, a first element, component, region, layer, or section discussed below could be termed a second element, component, region, layer, or section without departing from the teachings of the present invention.

Terminologies used herein are provided to merely mention specific embodiments and are not intended to limit the present invention. Singular expressions used herein include plurals unless they have definitely opposite meanings. The meaning of "including" used in this specification gives shape to specific characteristics, regions, positive numbers, steps, operations, elements, and/or components, and do not exclude the existence or addition of other specific characteristics, regions, positive numbers, steps, operations, elements, components, and/or groups.

Spatially relative terms, such as "below" and "above" and the like, may be used herein for ease of description to describe one element or feature's relationship to another element(s) or feature(s) as illustrated in the figures. It will be understood that spatially relative terms are intended to encompass different orientations of the device in use or operation in addition to the orientation depicted in the drawings. For example, if the device in the figures is turned over, elements described as "below" other elements or features would then be oriented "above" the other elements or features. Apparatuses may be otherwise rotated 90 degrees or at other angles, and the spatially relative descriptors used herein are then interpreted accordingly.

All the terminologies including technical terms and scientific terms used herein have the same meanings that those skilled in the art generally understand. Terms defined in dictionaries are construed to have meanings corresponding to related technical documents and the present description, and they are not construed as ideal or very official meanings, if not defined. Embodiments of the present invention described with reference to cross-sectional views represent ideal embodiments of the present invention in detail. Therefore, various modification of diagrams, for example, modifications of manufacturing methods and/or specifications, are expected. Accordingly, embodiments are not limited to specific shapes of shown regions, and for example, also include modifications of the shape by manufacturing. For example, regions shown or described as flat may generally have rough or rough and nonlinear characteristics. Further, portions shown to have sharp angles may be rounded. Therefore, the regions shown in the drawings are basically just schematic and the shapes thereof are not intended to show the exact shapes of the region and are also not intended to reduce the scope of the present invention.

In the specification, the term "flatness index" implies an index indicating height deviation of thin film interface in a perpendicular direction. If the flatness index is low, the height of interface is constant, that is, the interface is flat. On the contrary, if the flatness index is high, the height deviation of interface is great, that is, the interface is curved. In order to increase a regeneration signal of an element, it is preferably to form a flat interface by decreasing the flatness index of an insulating layer.

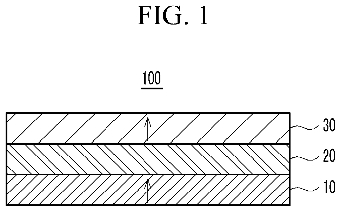

FIG. 1 schematically shows a cross-sectional structure of a magnetic tunnel junction device 100 according to an exemplary embodiment of the present invention. The cross-sectional structure of the magnetic tunnel junction device 100 shown in FIG. 1 is an example of the present invention, and the present invention is not limited thereto. That is, the cross-sectional structure of the magnetic tunnel junction device 100 can be modified in various shapes.

As shown in FIG. 1, the magnetic tunnel junction device 100 includes a first magnetic layer 10, an insulating layer 20, and a second magnetic layer 30. The first magnetic layer 10 functions as a fixed magnetic layer, and the second magnetic layer 30 functions as a free magnetic layer. In order to increase thermal stability of the magnetic tunnel junction device 100, the first and second magnetic layers 10 and 20 are formed of a ferromagnetic substance having perpendicular magnetic anisotropy when a crystal structure arranged as an L1₀ based alloy is recovered.

The first magnetic layer 10 and the second magnetic layer 30 respectively include a material having a chemical formula of (A₁₀₀₋ₓBₓ)_{100-y}C_{y}. Here, A and B may respectively be metal elements. In further detail, A may be iron (Fe), cobalt (Co), nickel (Ni), manganese (Mn), or chrome (Cr). In addition, B may be platinum (Pt), palladium (Pd), rhodium (Rh), gold (Au), mercury (Hg), or aluminum (Al). Further, C may be boron (B), carbon (C), tantalum (Ta), and hafnium (Hf).

An alloy having a chemical formula of A₁₀₀₋ₓBₓ has an arranged structure. The arranged structure may be a cubic structure or a tetragonal structure. The cubic structure may exemplarily include a crystal structure of an L1₂ type. In addition, the tetragonal structure may exemplarily include a crystal structure of L1₀. C is an alloy having a chemical formula of A₁₀₀₋ₓBₓ before thermal treatment for amorphization. The first magnetic layer 10 and the second magnetic layer 30 may be respectively formed of different materials or the same material.

The insulating layer 20 includes a compound having a chemical formula of D_{100-z}E_{z}. Here, D is at least one element selected from a group consisting of lithium (Li), beryllium (Be), sodium (Na), magnesium (Mg), niobium (Nb), titanium (Ti), vanadium (V), tantalum (Ta), barium (Ba), palladium (Pd), zirconium (Zr), holmium (Ho), potassium (K), and silver (Ag), and E is at least one element selected from a group consisting of oxygen (O), nitrogen (N), carbon (C), hydrogen (H), selenium (Se), chlorine (Cl), and fluorine (F). For example, the insulating layer 20 may be made of magnesium oxide (MgO).

The insulating layer 20 may have a cubic structure. The cubic structure may exemplarily include a crystal structure of a B1 type. The insulating layer may have a (001) orientation along a direction that is perpendicular to a substrate surface of a thin film interface for increasing a regeneration signal value of the magnetic tunnel junction device 100.

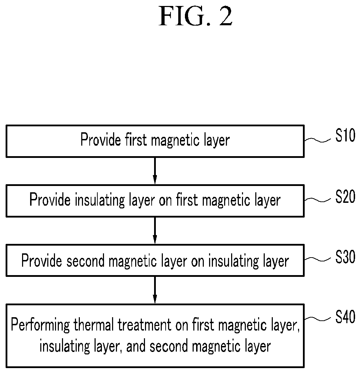

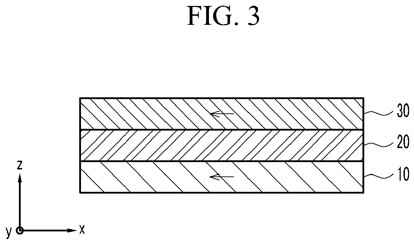

As shown by the arrow of FIG. 1, the first magnetic layer 10 and the second magnetic layer 30 have perpendicular magnetic anisotropy after recovering their crystal structures through thermal treatment. Accordingly, the magnetic tunnel junction device 100 having excellent thermal stability and a high regeneration signal value can be manufactured. Hereinafter, a manufacturing method of the magnetic tunnel junction device 100 of FIG. 1 will be described in further detail with reference to FIG. 2 and FIG. 3.

FIG. 2 schematically shows a flowchart of a manufacturing method of the magnetic tunnel junction device 100 of FIG. 1.

As shown in FIG. 2, the manufacturing method of the magnetic tunnel junction device 100 includes: i) providing the first magnetic layer 10 of FIG. 1 (S10); ii) providing the insulating layer 20 of FIG. 1 on the first magnetic layer 10 (S20); iii) providing the second magnetic layer 30 on the insulating layer 20 (S30); and thermally processing the first magnetic layer 10, the insulating layer 20, and the second magnetic layer 30 (S40). The manufacturing method of the magnetic tunnel junction device 100 may further include other steps.

In the step S10, the first magnetic layer 10 is provided for manufacturing the magnetic tunnel junction device 100. The first magnetic layer 10 may be formed by a deposition method. If the ferromagnetic substance with an arranged crystal structure and a perpendicular magnetic anisotropy is used, deposition of the first magnetic layer 10 is performed by adding an amorphizing element to the ferromagnetic substance. During the deposition process, the first magnetic layer 10 does not have perpendicular magnetic anisotropy. The first magnetic layer 10 has the perpendicular magnetic anisotropy by recovering a crystal structure through the thermal process of S40.

In the case that the first magnetic layer 10 has a crystal structure, a crystal lattice constant of the magnetic layer 10 may be greatly different from that of the insulating layer 20. In this case, the insulating layer 20 having a (001) orientation has difficulty in growth on the first magnetic layer 10. In addition, although the insulating layer 20 having the (001) orientation grows on the insulating layer 20, the flatness index of the insulating layer 20 is increased because the insulating layer 20 is greatly different from the first magnetic layer 10 in crystal lattice constant. Particularly, a lattice constant of an alloy structured in the type of L1₀ having strong perpendicular magnetic anisotropy is greatly different from that of magnesium oxide which is used as a material of the insulating layer 20. Therefore, it is difficult to grow magnesium oxide on the L1₀-structure alloy to the (001) orientation of a crystal structure of B1. Furthermore, although magnesium oxide is grown on the L1₀-structure alloy, the flatness index of the insulating layer 20 is increased due to a great difference in lattice constant therebetween, thereby causing a decrease of the regeneration signal value of the magnetic tunnel junction device 100.

However, the first magnetic layer 10 according to an exemplary embodiment of the present invention is amorphous so that the insulating layer 20 is grown well with the (001) orientation on the first magnetic layer 10. In addition, a crystal structure does not exist in the amorphous first magnetic layer 10. Thus, the first magnetic layer 10 and the insulating layer 20 do not have a crystal structure difference so that the flatness index of the insulating layer 20 is decreased. Accordingly, the regeneration signal value of the magnetic tunnel junction device 100 can be greatly increased. In the step S20, the insulating layer 20 is formed on the first magnetic layer 10. That is, the insulating layer 20 is deposited with the (001) orientation on the first magnetic layer 10. In addition, the flatness index of the insulating layer 20 is decreased.

In the step S30, the second magnetic layer 30 is formed on the insulating layer 20. The second magnetic layer 30 is amorphous. The second magnetic layer 30 can be manufactured by using the same method as that of the first magnetic layer 10 of the step S10.

FIG. 3 schematically shows a sequentially stacked first magnetic layer 10, insulating layer 20, and second magnetic layer 30 of the magnetic tunnel junction device before thermal treatment.

Since the first magnetic layer 10 and the second magnetic layer 30 formed with the amorphous phase are not crystalline before the thermal treatment is performed on the magnetic tunnel junction device, the first and second magnetic layers 10 and 30 do not have perpendicular magnetic anisotropy. Thus, as shown in FIG. 3, magnetized moments of the first and second magnetic layers 10 and 30 are formed along the x-axis direction, that is, the horizontal direction.

Referring back to FIG. 2, the first magnetic layer 10, the insulating layer 20, and the second magnetic layer 30 manufactured through the above-described method are thermally treated in the step S40. While the first magnetic layer 10, the insulating layer 20, and the second magnetic layer 30 experience the thermal treatment at a high temperature for a sufficient period of time, the first and second magnetic layers 10 and 30 having the chemical formula of (A₁₀₀₋ₓBₓ)_{100-y}C_{y} may be recovered to the arranged crystal structure. In further detail, the thermal treatment may be performed for several minutes to several hours at a temperature of 300°C to 600°C in order to prevent performance deterioration of the magnetic tunnel junction device due to diffusion of other elements.

The first and second magnetic layers 10 and 30 changed to amorphous ferromagnetic substances by the thermal treatment gain perpendicular magnetic anisotropy while being changed to the arranged crystal structure. That is, the magnetic tunnel junction device is manufactured by respectively depositing the first and second magnetic layers 10 and 30 in the amorphous phase and then the magnetic tunnel junction device is thermally treated according to an exemplary embodiment of the present invention. Thus, by inducing perpendicular magnetic anisotropy of the first and second magnetic layers 10 and 30, the regeneration signal value of the magnetic tunnel junction device 100 can be increased and thermal stability thereof can be increased with a small volume. Accordingly, perpendicular magnetic anisotropy of the magnetic tunnel junction device 100 can be assured while the first magnetic layer 10, the second magnetic layer 30, and the insulating layer 20 with materials having excellent signal characteristics are manufactured.

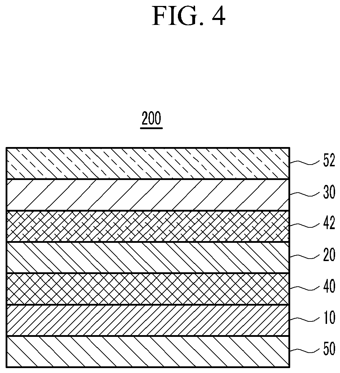

FIG. 4 schematically shows a cross-sectional view of a magnetic tunnel junction device 200 according to a first embodiment of the present invention. The magnetic tunnel junction device 200 of FIG. 4 is similar to the magnetic tunnel junction device 100 of FIG. 1, and therefore like reference numerals designate like elements and detailed description thereof will be omitted.

As shown in FIG. 4, the magnetic tunnel junction device 200 includes a first magnetic layer 10, an insulating layer 20, a second magnetic layer 30, horizontal anisotropic magnetic layers 40 and 42, and crystalline inductive layers 50 and 52. The horizontal anisotropic magnetic layers 40 and 42 are used to compensate a great difference in crystal structure between the magnetic layers 10 and 30 and the insulating layer 20. In addition, the horizontal anisotropic magnetic layers 40 and 42 may be used to increase a regeneration signal value of the magnetic tunnel junction device 200.

In this case, the insulating layer 20 matches the horizontal anisotropic magnetic layers 40 and 42, and the first magnetic layer 10 and the second magnetic layer 30 match the crystalline inductive layers 50 and 52. The first and second magnetic layers 10 and 30 having vertical anisotropy do not match the horizontal anisotropic magnetic layers 40 and 42, but they are magnetically connected thereto. Accordingly, the strong vertical anisotropy of the first and second magnetic layers 10 and 30 vertically arrange magnetic moments of the horizontal anisotropic magnetic layers 40 and 42 so that a magnetic tunnel junction having perpendicular magnetic anisotropy can be realized in the magnetic tunnel junction device 200.

The horizontal anisotropic magnetic layers 40 and 42 have a high spin polarization rate, and lattice constants thereof are slightly different from that of the insulating layer 20. The horizontal anisotropic magnetic layers 40 and 42 may be formed of a material such as Fe, CoFe, or CoFeB.

Meanwhile, the crystalline inductive layers 50 and 52 make the amorphous first and second magnetic layers 10 and 30 have an arranged crystal structure through thermal treatment without contacting the insulating layer 20. For example, when the first magnetic layer 10 and the second magnetic layer 30 are formed of FePdB or FePtB, Pd, Pt, Au, or Fe is grown to have a (100) orientation so as to be used as a material of the crystalline inductive layers 50 and 52.

As described above, although the first and second magnetic layers 10 and 30 and the insulating layer 20 are greatly different from each other in crystal structure, perpendicular magnetic anisotropy of the magnetic tunnel junction device 200 can be realized by using the horizontal anisotropic magnetic layers 40 and 42 and the crystalline inductive layers 50 and 52.

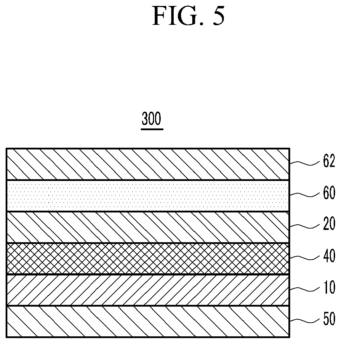

FIG. 5 schematically shows a cross-sectional view of a magnetic tunnel junction device 300 according to a second embodiment of the present invention. The magnetic tunnel junction device 300 of FIG. 5 is similar to the magnetic tunnel junction device 200 of FIG. 4, and therefore like reference numerals designate like elements and detailed description thereof will be omitted.

As shown in FIG. 5, the magnetic tunnel junction device 300 includes a first magnetic layer 10, an insulating layer 20, a horizontal anisotropic magnetic layer 40, a crystalline inductive layer 50, a horizontal anisotropic magnetic layer 60, and a perpendicular magnetic anisotropic inductive layer 62.

A structure of the insulating layer 20 of the magnetic tunnel junction device 300 of FIG. 5 is the same as that of the magnetic tunnel junction device 200, excluding an upper structure thereof.

As shown in FIG. 5, the magnetic tunnel junction device 300 may use an amorphous material at one side and a crystalline material at the other end as a perpendicular magnetic anisotropic inductive layer. After thermal treatment, the amorphous material becomes the first magnetic layer 10 and the crystalline material becomes the perpendicular magnetic anisotropic inductive layer 62. In FIG. 5, an amorphous material is used as a perpendicular magnetic anisotropic inductive layer in a lower portion of the insulating layer 20. In this case, the lower structure of the insulating layer 20 is the same as that of the insulating layer 20 of the magnetic tunnel junction device of FIG. 4.

As shown in FIG. 5, the horizontal anisotropic magnetic layer 50 and the crystalline perpendicular magnetic anisotropic inductive layer 62 are formed in an upper portion of the insulating layer 20 of the magnetic tunnel junction device 300. For example, the horizontal anisotropic magnetic layer 50 may be formed of a CoFeB alloy, and the perpendicular magnetic anisotropic inductive layer 62 may be formed of a multi-layered Co/Pt alloy.

Hereinafter, the present invention will be described in further detail through experimental examples. The experimental examples are provided as examples of the present invention, and therefore the present invention is not limited thereto.

### Experimental Example 1

A magnetic tunnel junction device was manufactured by sequentially stacking a magnetic layer, an insulating layer, and a magnetic layer. The magnetic layer was manufactured by adding 20at% of boron to a Fe₅₀Pd₅₀ alloy having 1:1 element contents: the Fe₅₀Pd₅₀ alloy had an arranged crystal structure and perpendicular magnetic anisotropy, the magnetic layer was amorphized by adding boron. The thickness of the magnetic layer was 3nm.

Next, the insulating layer was deposited on the magnetic layer. The insulating layer was formed of magnesium oxide, and had a thickness of 10nm. The magnetic layer formed of (Fe₅₀Pd₅₀)₈₀B₂₀ was deposited on the insulating layer.

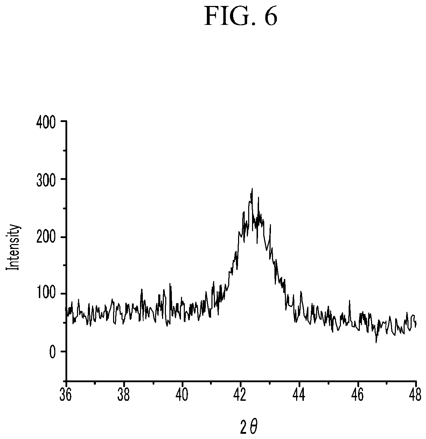

FIG. 6 shows an X-ray diffraction graph of a magnetic tunnel junction device manufactured according to Experimental Example 1.

As shown in FIG. 6, the X-ray diffraction peak was observed at a location where 2θ is approximately 43°. This implies that MgO, that is, the insulating layer, was grown with a (001) orientation. Accordingly, it shows that the insulating layer was grown with a (001) orientation on the magnetic layer. In addition, since the insulating layer was deposited on the amorphized magnetic layer, it is predicted that the flatness index of the insulating layer would be low.

### Experimental Example 2

A Pt layer was deposited at 40nm to have a (001) orientation on a single crystal substrate formed of MgO having a (001) orientation. Here, the Pt layer had a thickness of 40nm, and functioned as a crystalline inductive layer of an amorphous magnetic layer. Next, a magnetic layer formed of (Fe₅₀Pd₅₀)₈₀B₂₀ was deposited in the amorphous phase on the Pt layer. The thickness of the magnetic layer formed of (Fe₅₀Pd₅₀)₈₀B₂₀ was 10nm. The magnetic layer was deposited and thermal treatment was performed for one hour at 500 °C.

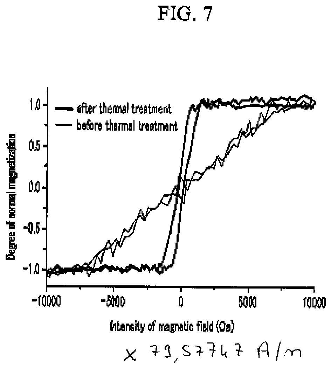

FIG. 7 shows a magnetic hysteresis curve of a magnetic layer of a magnetic tunnel junction device manufactured according to the second experimental example before thermal treatment and after thermal treatment. Here, the magnetic layer is formed of (Fe₅₀Pd₅₀)₈₀B₂₀. In FIG. 7, the thin line indicates a degree of normal magnetization in the amorphous phase before thermal treatment, and the thick line indicates a degree of normal magnetization in the state that a crystal structure is recovered after thermal treatment.

As shown in FIG. 7, intensity of magnetization was increased in proportion to a magnetic field before the magnetic layer formed of (Fe₅₀Pd₅₀)₈₀B₂₀ is thermally treated, and the magnetization of the magnetic layer was saturated around 7000.10³/4π A/m (7000 Oe) which is a value of a demagnetization field value generated from a shape deposited in a thin film state. A saturation magnetic moment of the magnetic layer formed of (Fe₅₀Pd₅₀)₈₀B₂₀ was 560.10³ A/m (560 emu/cc), and the demagnetization field value was 7000.10³/4π A/m (7000 Oe) when the deposited shape was a thin film. That is, since the magnetic layer formed of (Fe₅₀Pd₅₀)₈₀B₂₀ does not have a crystal structure before the thermal treatment, the magnetic layer had horizontal magnetic anisotropy without assuring perpendicular magnetic anisotropy. However, after the magnetic layer formed of (Fe₅₀Pd₅₀)₈₀B₂₀ is thermally treated, the magnetization of the magnetic layer was saturated around 1000.10³/4π A/m (1000 Oe) which is smaller than 7000.10³/4π A/m (7000 Oe). That is, the perpendicular magnetic anisotropy was assured while a crystal structure of the magnetic layer formed of (Fe₅₀Pd₅₀)₈₀B₂₀ was recovered after the thermal treatment.

## Claims

1. A magnetic tunnel junction device (200) comprising:
a first magnetic layer (10) including B, boron, as an amorphizing element, with a perpendicular magnetic anisotropy ;
an insulating layer (20) disposed on the first magnetic layer;
a second magnetic layer (30) including B, boron, as an amorphizing element, with a perpendicular magnetic anisotropy disposed on the insulating layer (20);
a first horizontal magnetic anisotropic magnetic layer (40) disposed between the second magnetic layer (30) and the insulating layer (20); and
a first crystalline inductive layer (50,52) disposed on the second magnetic layer (30);
wherein
at least one of the first and second magnetic layers (10, 30) including a compound having a chemical formula of (Fe₁₀₀₋ₓPdₓ)_{100-y}B_{y} or (Fe₁₀₀₋ₓPtₓ)_{100-y}B_{y}; and
the first crystalline inductive layer (50) includes at least one element selected from a group consisting of Pd, Pt, Au, and Fe and has a (100) orientation.

2. The magnetic tunnel junction device (200) of claim 1, wherein the insulating layer (20) includes a compound having a chemical formula of D100-zEz, and D is at least one element selected from a group consisting of lithium (Li), beryllium (Be), sodium (Na), magnesium (Mg), niobium (Nb), titanium (Ti), vanadium (V), tantalum (Ta), barium (Ba), palladium (Pd), zirconium (Zr), holmium (Ho), potassium (K), and silver (Ag), and E is at least one element selected from a group consisting of oxygen (O), nitrogen (N), carbon (C), hydrogen (H), selenium (Se), chlorine (Cl), and fluorine (F).

3. The magnetic tunnel junction device (200) of claim 1, wherein at least one of the first and second magnetic layers (10, 30) has a cubic or tetragonal structure.

4. The magnetic tunnel junction device (200) of claim 1, wherein the first horizontal magnetic anisotropic magnetic layer (40) comprises at least one element selected from a group consisting of Fe, CoFe, and CoFeB.

5. The magnetic tunnel junction device (200) of claim 1, further comprising:
a second horizontal magnetic anisotropic magnetic layer (42) disposed between the first magnetic layer (10) and the insulating layer (20); and
a second crystalline inductive layer (52) disposed under the first magnetic layer (10).

6. A magnetic tunnel junction device (300) comprising:
a crystalline inductive layer (50);
a perpendicular magnetic anisotropic magnetic layer (10) including B, boron, as an amorphizing element disposed on the crystalline inductive layer (50) and including a compound having a chemical formula of (Fe₁₀₀₋ₓPdₓ)_{100-y}B_{y} or (Fe₁₀₀₋ₓPtₓ)_{100-y}B_{y};
a horizontal magnetic anisotropic magnetic layer (40) disposed on the perpendicular magnetic anisotropic magnetic layer (10);
an insulating layer (20) disposed on the horizontal magnetic anisotropic magnetic layer (40);
a horizontal magnetic anisotropic magnetic layer (60) disposed on the insulating layer (20); and
a perpendicular magnetic inductive magnetic layer (62) disposed on the horizontal magnetic anisotropic magnetic layer (60),
wherein the crystalline inductive layer (50) includes at least one element selected from a group consisting of Pd, Pt, Au, and Fe and has a (100) orientation.

7. A manufacturing method of a magnetic tunnel junction device (200), comprising:
providing a first magnetic layer (10) including B, boron, as an amorphizing element;
providing an insulating layer (20) on the first magnetic layer (10);
providing a second magnetic layer (30) including B, boron, as an amorphizing element on the insulating layer (20);
providing a first horizontal magnetic anisotropic magnetic layer (40) disposed between the second magnetic layer (30) and the insulating layer (20);
a first crystalline inductive layer (50) disposed on the second magnetic layer (30); and
crystallizing the first and second magnetic layers (10, 30) by performing thermal treatment on the first magnetic layer (10), the insulating layer (20), the first horizontal magnetic anisotropic magnetic layer (40), the second magnetic layer (30), and the first crystalline inductive layer (50), wherein at least one of the first and second magnetic layers (10, 30) includes a compound having a chemical formula of (Fe₁₀₀₋ₓPdₓ)_{100-y}B_{y} or (Fe₁₀₀₋ₓPtₓ)_{100-y}B_{y}, and
the first crystalline inductive layer (50) includes at least one element selected from a group consisting of Pd, Pt, Au, and Fe and has a (100) orientation.

8. The manufacturing method of claim 7, wherein in the crystallizing of the first and second magnetic layers (10, 30), the first and second magnetic layers (10, 30) have perpendicular magnetic anisotropy.

9. The manufacturing method of claim 7, wherein in the crystallizing of the first and second magnetic layers (10, 30), the thermal treatment is performed on the first magnetic layer (10), the insulating layer (20), the first horizontal magnetic anisotropic magnetic layer (40), the second magnetic layer (30), and the first crystalline inductive layer (50) at 300[deg.]C to 600[deg.]C.

10. The manufacturing method of claim 7, further comprising:
providing another horizontal magnetic anisotropic magnetic layer (42) between the first magnetic layer (10) and the insulating layer (20); and
providing a crystalline inductive layer (52) under the first magnetic layer (10).

11. A manufacturing method of a magnetic tunnel junction device (300), comprising:
providing a crystalline inductive layer (50);
providing a magnetic layer (10) including B, boron, as an amorphizing element, on the crystalline inductive layer (50);
providing a first horizontal magnetic anisotropic magnetic layer (40) on the magnetic layer (10);
providing an insulating layer (20) on the first horizontal magnetic anisotropic magnetic layer (40);
providing a second horizontal magnetic anisotropic magnetic layer (60) on the insulating layer (20);
providing a perpendicular magnetic anisotropic magnetic layer (62) on the second horizontal magnetic anisotropic magnetic layer (60); and
crystallizing the magnetic layer (10) by performing thermal treatment on the crystalline inductive layer (50), the magnetic layer (10), the first horizontal magnetic anisotropic magnetic layer (40), the insulating layer (20), the second horizontal magnetic anisotropic magnetic layer (60), and the perpendicular magnetic anisotropic magnetic layer (62),
wherein, in the crystallizing of the magnetic layer (10), the magnetic layer (10) has perpendicular magnetic anisotropy and includes a compound having a chemical formula of (Fe₁₀₀₋ₓPdₓ)_{100-y}B_{y} or (Fe₁₀₀₋ₓPtₓ)_{100-y}B_{y}, and
the crystalline inductive layer (50) includes at least one element selected from a group consisting of Pd, Pt, Au, and Fe and has a (100) orientation.

## Patentansprüche

1. Vorrichtung mit magnetischem Tunnelübergang (200), umfassend:
eine erste Magnetschicht (10) mit einer senkrechten magnetischen Anisotropie, die B, Bor, als ein Element zum Überführen in den amorphen Zustand enthält;
eine Isolierschicht (20), die auf der ersten Magnetschicht angeordnet ist;
eine auf der Isolierschicht (20) angeordnete zweite Magnetschicht (30) mit einer senkrechten magnetischen Anisotropie, die B, Bor, als ein Element zum Überführen in den amorphen Zustand enthält;
eine erste horizontal magnetisch anisotrope Magnetschicht (40), die zwischen der zweiten Magnetschicht (30) und der Isolierschicht (20) angeordnet ist; und
eine erste kristalline Induktionsschicht (50, 52), die auf der zweiten Magnetschicht (30) angeordnet ist;
wobei
wenigstens eine aus der ersten und zweiten Magnetschicht (10, 30) eine Verbindung enthält, die eine chemische Formel von (Fe₁₀₀₋ₓPdₓ)_{100-y}B_{y} oder (Fe₁₀₀₋ₓPtₓ)_{100-y}B_{y} besitzt;
und
die erste kristalline Induktionsschicht (50) wenigstens ein Element enthält, das aus einer Gruppe bestehend aus Pd, Pt, Au, und Fe ausgewählt ist und eine (100) Orientierung besitzt.

2. Vorrichtung mit magnetischem Tunnelübergang (200) nach Anspruch 1, wobei die Isolierschicht (20) eine Verbindung enthält, die eine chemische Formel von D100-zEz besitzt, und D wenigstens ein Element ist, das aus einer Gruppe bestehend aus Lithium (Li), Beryllium (Be), Natrium (Na), Magnesium (Mg), Niob (Nb), Titan (Ti), Vanadium (V), Tantal (Ta), Barium (Ba), Palladium (Pd), Zirkonium (Zr), Holmium (Ho), Kalium (K), und Silber (Ag) ausgewählt ist, und E wenigstens ein Element ist, das aus einer Gruppe bestehend aus Sauerstoff (O), Stickstoff (N), Kohlenstoff (C), Wasserstoff (H), Selen (Se), Chlor (Cl), und Fluor (F) ausgewählt ist.

3. Vorrichtung mit magnetischem Tunnelübergang (200) nach Anspruch 1, wobei wenigstens eine aus der ersten und zweiten Magnetschicht (10, 30) eine kubische oder tetragonale Struktur besitzt.

4. Vorrichtung mit magnetischem Tunnelübergang (200) nach Anspruch 1, wobei die erste horizontal magnetisch anisotrope Magnetschicht (40) wenigstens ein Element umfasst, das aus einer Gruppe bestehend aus Fe, CoFe, und CoFeB ausgewählt ist.

5. Vorrichtung mit magnetischem Tunnelübergang (200) nach Anspruch 1, weiter umfassend:
eine zweite horizontal magnetisch anisotrope Magnetschicht (42), die zwischen der ersten Magnetschicht (10) und der Isolierschicht (20) angeordnet ist; und
eine zweite kristalline Induktionsschicht (52), die unter der ersten Magnetschicht (10) angeordnet ist.

6. Vorrichtung mit magnetischem Tunnelübergang (300), umfassend:
eine kristalline Induktionsschicht (50);
eine senkrecht magnetisch anisotrope Magnetschicht (10), die B, Bor, als ein Element zum Überführen in den amorphen Zustand enthält, die auf der kristallinen Induktionsschicht (50) angeordnet ist und eine Verbindung enthält, die eine chemische Formel von (Fe₁₀₀₋ₓPdₓ)_{100-y}B_{y} oder (Fe₁₀₀₋ₓPtₓ)_{100-y}B_{y} besitzt;
eine horizontal magnetisch anisotrope Magnetschicht (40), die auf der senkrecht magnetisch anisotropen Magnetschicht (10) angeordnet ist;
eine Isolierschicht (20), die auf der horizontal magnetisch anisotropen Magnetschicht (40) angeordnet ist;
eine horizontal magnetisch anisotrope Magnetschicht (60), die auf der Isolierschicht (20) angeordnet ist; und
eine senkrecht magnetisch induktive Magnetschicht (62), die auf der horizontal magnetisch anisotropen Magnetschicht (60) angeordnet ist,
wobei die kristalline Induktionsschicht (50) wenigstens ein Element enthält, das aus einer Gruppe bestehend aus Pd, Pt, Au, und Fe ausgewählt ist und eine (100) Orientierung besitzt.

7. Herstellungsverfahren einer Vorrichtung mit magnetischem Tunnelübergang (200), umfassend:
Bereitstellen einer ersten Magnetschicht (10), die B, Bor, als ein Element zum Überführen in den amorphen Zustand enthält;
Bereitstellen einer Isolierschicht (20) auf der ersten Magnetschicht (10);
Bereitstellen einer zweiten Magnetschicht (30), die B, Bor, als ein Element zum Überführen in den amorphen Zustand enthält, auf der Isolierschicht (20);
Bereitstellen einer ersten horizontal magnetisch anisotropen Magnetschicht (40), die zwischen der zweiten Magnetschicht (30) und der Isolierschicht (20) angeordnet ist;
eine erste kristalline Induktionsschicht (50), die auf der zweiten Magnetschicht (30) angeordnet ist; und
Kristallisieren der ersten und zweiten Magnetschicht (10, 30) durch Durchführen von thermischer Behandlung an der ersten Magnetschicht (10), der Isolierschicht (20), der ersten horizontal magnetisch anisotropen Magnetschicht (40), der zweiten Magnetschicht (30), und der ersten kristallinen Induktionsschicht (50),
wobei wenigstens eine aus der ersten und zweiten Magnetschicht (10, 30) eine Verbindung enthält, die eine chemische Formel von (Fe₁₀₀₋ₓPdₓ)_{100-y}B_{y} oder (Fe₁₀₀₋ₓPtₓ)_{100-y}B_{y} besitzt, und
die erste kristalline Induktionsschicht (50) wenigstens ein Element enthält, das aus einer Gruppe bestehend aus Pd, Pt, Au, und Fe ausgewählt ist und eine (100) Orientierung besitzt.

8. Herstellungsverfahren nach Anspruch 7, wobei beim Kristallisieren der ersten und zweiten Magnetschicht (10, 30) die erste und zweite Magnetschicht (10, 30) senkrechte magnetische Anisotropie besitzen.

9. Herstellungsverfahren nach Anspruch 7, wobei beim Kristallisieren der ersten und zweiten Magnetschicht (10, 30) die thermische Behandlung an der ersten Magnetschicht (10), der Isolierschicht (20), der ersten horizontal magnetisch anisotropen Magnetschicht (40), der zweiten Magnetschicht (30), und der ersten kristallinen Induktionsschicht (50) bei 300 [Grad] C bis 600 [Grad] C durchgeführt wird.

10. Herstellungsverfahren nach Anspruch 7, weiter umfassend:
Bereitstellen einer weiteren horizontal magnetisch anisotropen Magnetschicht (42) zwischen der ersten Magnetschicht (10) und der Isolierschicht (20); und
Bereitstellen einer kristallinen Induktionsschicht (52) unter der ersten Magnetschicht (10).

11. Herstellungsverfahren einer Vorrichtung mit magnetischem Tunnelübergang (300), umfassend:
Bereitstellen einer kristallinen Induktionsschicht (50);
Bereitstellen einer Magnetschicht (10), die B, Bor, als ein Element zum Überführen in den amorphen Zustand enthält, auf der kristallinen Induktionsschicht (50);
Bereitstellen einer ersten horizontal magnetisch anisotropen Magnetschicht (40) auf der Magnetschicht (10);
Bereitstellen einer Isolierschicht (20) auf der ersten horizontal magnetisch anisotropen Magnetschicht (40);
Bereitstellen einer zweiten horizontal magnetisch anisotropen Magnetschicht (60) auf der Isolierschicht (20);
Bereitstellen einer senkrecht magnetisch anisotropen Magnetschicht (62) auf der zweiten horizontal magnetisch anisotropen Magnetschicht (60); und
Kristallisieren der Magnetschicht (10) durch Durchführen von thermischer Behandlung an der kristallinen Induktionsschicht (50), der Magnetschicht (10), der ersten horizontal magnetisch anisotropen Magnetschicht (40), der Isolierschicht (20), der zweiten horizontal magnetisch anisotropen Magnetschicht (60), und der senkrecht magnetisch anisotropen Magnetschicht (62),
wobei, beim Kristallisieren der Magnetschicht (10), die Magnetschicht (10) senkrechte magnetische Anisotropie besitzt und eine Verbindung enthält, die eine chemische Formel von (Fe₁₀₀₋ₓPdₓ)_{100-y}B_{y} oder (Fe₁₀₀₋ₓPtₓ)_{100-y}B_{y} besitzt, und
die kristalline Induktionsschicht (50) wenigstens ein Element enthält, das aus einer Gruppe bestehend aus Pd, Pt, Au, und Fe ausgewählt ist und eine (100) Orientierung besitzt.

## Revendications

1. Dispositif à jonction à effet tunnel magnétique (200) comprenant :
une première couche magnétique (10) comportant B, le bore, en tant qu'élément amorphisant, ayant une anisotropie magnétique perpendiculaire ;
une couche isolante (20) disposée sur la première couche magnétique ;
une deuxième couche magnétique (30) comportant B, le bore, en tant qu'élément amorphisant, ayant une anisotropie magnétique perpendiculaire disposée sur la couche isolante (20) ;
une première couche magnétique anisotrope magnétique horizontale (40) disposée entre la deuxième couche magnétique (30) et la couche isolante (20) ; et
une première couche inductive cristalline (50, 52) disposée sur la deuxième couche magnétique (30) ;
dans lequel
au moins l'une des première et deuxième couches magnétiques (10, 30) comportant un composé ayant la formule chimique (Fe₁₀₀₋ₓPdₓ)_{100-y}B_{y} ou (Fe₁₀₀₋ₓPtₓ)_{100-y}B_{y}; et
la première couche inductive cristalline (50) comporte au moins un élément choisi dans un groupe constitué de Pd, Pt, Au et Fe et a une orientation (100).

2. Dispositif à jonction à effet tunnel magnétique (200) de la revendication 1, dans lequel la couche isolante (20) comporte un composé ayant la formule chimique D100-zEz, et D représente au moins un élément choisi dans un groupe constitué de lithium (Li), de béryllium (Be), de sodium (Na), de magnésium (Mg), de niobium (Nb), de titane (Ti), de vanadium (V), de tantale (Ta), de baryum (Ba), de palladium (Pd), de zirconium (Zr), d'holmium (Ho), de potassium (K) et d'argent (Ag), et E représente au moins un élément choisi dans un groupe constitué d'oxygène (O), d'azote (N), de carbone (C), d'hydrogène (H), de sélénium (Se), de chlore (Cl) et de fluor (F).

3. Dispositif à jonction à effet tunnel magnétique (200) de la revendication 1, dans lequel au moins l'une des première et deuxième couches magnétiques (10, 30) a une structure cubique ou tétragonale.

4. Dispositif à jonction à effet tunnel magnétique (200) de la revendication 1, dans lequel la première couche magnétique anisotrope horizontale (40) comprend au moins un élément choisi dans un groupe constitué de Fe, CoFe et CoFeB.

5. Dispositif à jonction à effet tunnel magnétique (200) de la revendication 1, comprenant en outre :
une deuxième couche magnétique anisotrope magnétique horizontale (42) disposée entre la première couche magnétique (10) et la couche isolante (20) ; et
une deuxième couche inductive cristalline (52) disposée sous la première couche magnétique (10).

6. Dispositif à jonction à effet tunnel magnétique (300) comprenant :
une couche inductive cristalline (50) ;
une couche magnétique anisotrope magnétique perpendiculaire (10) comportant B, le bore, en tant qu'élément amorphisant, disposée sur la couche inductive cristalline (50) et comportant un composé ayant la formule chimique (Fe₁₀₀₋ₓPdₓ)_{100-y}B_{y} ou (Fe₁₀₀₋ₓPtₓ)_{100-y}B_{y};
une couche magnétique anisotrope magnétique horizontale (40) disposée sur la couche magnétique anisotrope magnétique perpendiculaire (10) ;
une couche isolante (20) disposée sur la couche magnétique anisotrope magnétique horizontale (40) ;
une couche magnétique anisotrope magnétique horizontale (60) disposée sur la couche isolante (20) ; et
une couche magnétique inductive magnétique perpendiculaire (62) disposée sur la couche magnétique anisotrope magnétique horizontale (60),
dans lequel la couche inductive cristalline (50) comporte au moins un élément choisi dans un groupe constitué de Pd, Pt, Au et Fe et a une orientation (100).

7. Procédé de fabrication d'un dispositif à jonction à effet tunnel magnétique (200), comprenant le fait :
de fournir une première couche magnétique (10) comportant B, le bore, en tant qu'élément amorphisant ;
de fournir une couche isolante (20) sur la première couche magnétique (10) ;
de fournir une deuxième couche magnétique (30) comportant B, le bore, en tant qu'élément amorphisant sur la couche isolante (20) ;
de fournir une première couche magnétique anisotrope magnétique horizontale (40) disposée entre la deuxième couche magnétique (30) et la couche isolante (20) ;
de fournir une première couche inductive cristalline (50) disposée sur la deuxième couche magnétique (30) ; et
de cristalliser les première et deuxième couches magnétiques (10, 30) en effectuant un traitement thermique sur la première couche magnétique (10), la couche isolante (20), la première couche magnétique anisotrope magnétique horizontale (40), la deuxième couche magnétique (30) et la première couche inductive cristalline (50),
dans lequel au moins l'une des première et deuxième couches magnétiques (10, 30) comporte un composé ayant la formule chimique (Fe₁₀₀₋ₓPdₓ)_{100-y}B_{y} ou (Fe₁₀₀₋ₓPtₓ)_{100-y}B_{y}, et
la première couche inductive cristalline (50) comporte au moins un élément choisi dans un groupe constitué de Pd, Pt, Au et Fe et a une orientation (100).

8. Procédé de fabrication de la revendication 7, dans lequel, lors de la cristallisation des première et deuxième couches magnétiques (10, 30), les première et deuxième couches magnétiques (10, 30) ont une anisotropie magnétique perpendiculaire.

9. Procédé de fabrication de la revendication 7, dans lequel, lors de la cristallisation des première et deuxième couches magnétiques (10, 30), le traitement thermique est effectué sur la première couche magnétique (10), la couche isolante (20), la première couche magnétique anisotrope magnétique horizontale (40), la deuxième couche magnétique (30) et la première couche inductive cristalline (50) à une température comprise entre 300°C et 600°C.

10. Procédé de fabrication de la revendication 7, comprenant en outre le fait :
de fournir une autre couche magnétique anisotrope magnétique horizontale (42) entre la première couche magnétique (10) et la couche isolante (20) ; et
de fournir une couche inductive cristalline (52) sous la première couche magnétique (10).

11. Procédé de fabrication d'un dispositif à jonction à effet tunnel magnétique (300), comprenant le fait :
de fournir une couche inductive cristalline (50) ;
de fournir une couche magnétique (10) comportant B, le bore, en tant qu'élément amorphisant, sur la couche inductive cristalline (50) ;
de fournir une première couche magnétique anisotrope magnétique horizontale (40) sur la couche magnétique (10) ;
de fournir une couche isolante (20) sur la première couche magnétique anisotrope magnétique horizontale (40) ;
de fournir une deuxième couche magnétique anisotrope magnétique horizontale (60) sur la couche isolante (20) ;
de fournir une couche magnétique anisotrope magnétique perpendiculaire (62) sur la deuxième couche magnétique anisotrope magnétique horizontale (60) ; et
de cristalliser la couche magnétique (10) en effectuant un traitement thermique sur la couche inductive cristalline (50), la couche magnétique (10), la première couche magnétique anisotrope magnétique horizontale (40), la couche isolante (20), la deuxième couche magnétique anisotrope magnétique horizontale (60) et la couche magnétique anisotrope magnétique perpendiculaire (62),
dans lequel, lors de la cristallisation de la couche magnétique (10), la couche magnétique (10) a une anisotropie magnétique perpendiculaire et comporte un composé ayant la formule chimique (Fe₁₀₀₋ₓPdₓ)_{100-y}B_{y} ou (Fe₁₀₀₋ₓPtₓ)_{100-y}B_{y}, et
la couche inductive cristalline (50) comporte au moins un élément choisi dans un groupe constitué de Pd, Pt, Au et Fe et a une orientation (100).
